**Europäisches Patentamt**

**European Patent Office**

**Office européen des brevets**

(19)

(11) Veröffentlichungsnummer: **0 159 405**
**B1**

(12)

# EUROPÄISCHE PATENTSCHRIFT

(45) Veröffentlichungstag der Patentschrift:
02.09.87

(51) Int. Cl.⁴: **H 01 L 39/24, C 22 C 1/09**

(21) Anmeldenummer: **84115810.8**

(22) Anmeldetag: **19.12.84**

(54) **Verfahren zur Herstellung eines Filamente enthaltenden Verbundkörpers.**

(30) Priorität: **05.04.84 DE 3412837**

(43) Veröffentlichungstag der Anmeldung:
**30.10.85 Patentblatt 85/44**

(45) Bekanntmachung des Hinweises auf die Patenterteilung:
**02.09.87 Patentblatt 87/36**

(84) Benannte Vertragsstaaten:
**CH DE FR GB LI NL**

(56) Entgegenhaltungen:
GB-A-1 178 117
GB-A-2 003 766
GB-A-2 050 878

(73) Patentinhaber: **VACUUMSCHMELZE GMBH, Grüner Weg 37 Postfach 2253, D-6450 Hanau 1 (DE)**

(72) Erfinder: **Hillmann, Hans, Dr., Würzburger Strasse 55, D-6458 Rodenbach (DE)**

## Beschreibung

Die Erfindung betrifft ein Verfahren zur Herstellung eines draht- bzw. stabförmigen Verbundkörpers mit einer Vielzahl von Filamenten, die im wesentlichen parallel zur Längsachse des Verbundkörpers verlaufen und mit Abstand voneinander in den Verbundkörper eingebettet und durch querschnittsvermindernde Verformung mit dem übrigen Material des Verbundkörpers fest verbunden sind, wobei die Filamente vor der Verformung zunächst in Form einer Matte vorliegen und die Matte zu einer Rolle aufgewickelt wird.

In der Zeitschrift IEEE TRANSACTIONS ON MAGNETICS, Vol. MAG-19, No. 3, Mai 1983, Seiten 1124 bis 1127, ist ein Verbundkörper beschrieben, der eine Vielzahl von Filamenten aus Niob enthält und als Supraleiter Verwendung findet. Um sehr viele Filamente in einem einzigen Arbeitsgang in den Leiter einzuschließen, werden netzförmig ausgestanzte Bleche, sogenannte Streckmetalle, jeweils zu einer Rolle aufgewickelt und dann in ein Hüllrohr eingeführt. Der so gebildete Bolzen wird gepreßt und gezogen, so daß sich sein Querschnitt erheblich vermindert. Hierdurch reißen die Querbrücken in dem Streckmetall weitgehend ab, so daß sich in dem gebildeten Verbundkörper einzelne Filamente aus Niob befinden. Das übrige Material des Verbundkörpers besteht für den Einsatz als Supraleiter meistens aus Kupfer und Zinn, so daß durch eine Wärmebehandlung die Niobfilamente eine supraleitende $Nb_3Sn$-Schicht erhalten.

Ein weiteres, schon wesentlich länger bekanntes Verfahren zur Herstellung eines Verbundkörpers mit einer Vielzahl von Filamenten ist beispielsweise in der DE-OS 32 07 159 beschrieben. Der dort dargestellte Verbundleiter wird aus Stäben zusammengesetzt, von denen jeder bereits aus mehreren in Bronze eingebetteten Niobstäben besteht. Um also einen Verbundkörper mit sehr vielen Filamenten herzustellen, hat man zwei Bündelungsschritte hintereinander durchführen müssen.

Das in der Zeitschrift IEEE TRANSACTIONS ON MAGNETICS beschriebene Fertigungsverfahren kommt demgegenüber auch bei relativ vielen einzuschließenden Filamenten mit nur einem Bündelungsschritt aus. Gegenüber dem in der genannten DE-OS 32 07 159 dargestellten Leiter müssen jedoch auch Nachteile in Kauf genommen werden. Außerdem haben die die Filamente bildenden Stege des Streckmetallbleches zwangsläufig einen gestreckten, rechteckigen bzw. ovalen Querschnitt. Dies verursacht bei der Querschnittsverminderung durch Pressen oder Ziehen eine unsymmetrische Querschnittsverminderung und Kerbwirkung, vor allem bedingt durch die auftretenden großen Kraftkomponenten in radialer Richtung. Hierdurch wird das Ausmaß der zulässigen Querschnittsverminderung begrenzt. Dies hat zur Folge, daß nur relativ geringe Durchmesser des ursprünglichen, die Rolle enthaltenden Bolzens Verwendung finden können, so daß die herzustellenden Längen des Verbundkörpers gegenüber der Methode mit Mehrfachbündelung begrenzt sind.

Da bei der Verwendung der Filamente als Träger für eine supraleitende Schicht jeweils die größte Abmessung eines Filamentes für die bei Wechselstrom auftretenden Wirbel- und Hystereseverluste entscheidend ist, besitzt das Verfahren der Mehrfachbündelung wesentliche Vorteile dadurch, daß dort runde Querschnitte für die Filamente verwendet werden können. So kann es vorkommen, daß die zwischen den in Längsrichtung verlaufenden Filamenten bestehenden Verbindungen in dem Streckmetall bei der Querschnittsverminderung nicht vollständig abreißen und so Brücken zwischen den Filamenten erhalten bleiben, die im Falle der Verwendung als Supraleiter bei Wechselstrom Wirbel- und Hystereseverluste verursachen.

Weiterhin ist es einfach, durch Mehrfachbündelung den für die Verwendung als Supraleiter optimalen Durchmesser der Filamente von etwa 3 μ bei großen Längen des Verbundkörpers einzustellen.

Ein Filamentdurchmesser von 3 μ wird bei $Nb_3Sn$-Supraleitern deswegen als optimal angesehen, da sich dann durch Feststoffdiffusion eine $Nb_3Sn$-Schicht von etwa 1 μ bilden kann. Diese Schichtdicke bestimmt die für den Strom zur Verfügung stehende Querschnittsfläche. Durch das Vergrößern dieser Schicht bei der Diffusion von Zinn in das Niob vergrößern sich jedoch auch die Kristalle in der $Nb_3Sn$-Schicht und damit verringert sich die Zahl der Korngrenzen, an denen sich bei einwirkendem Wechselfeld die magnetischen Flußlinien festhalten können.

Die maximal erreichbare Stromdichte hängt aber von der Anzahl dieser Korngrenzen ab, so daß man sagen kann, daß eine zunehmende Schichtdicke einerseits die Querschnittsfläche für den Strom vergrößert, jedoch andererseits die maximal erreichbare Stromdichte verringert. Da die Stromtragfähigkeit das Produkt aus diesen zwei Größen ist, gibt es einen optimalen Bereich für die einzustellende Schichtdicke, der bei $Nb_3Sn$-Supraleitern etwa bei 1 μ liegt.

Aber auch für andere Anwendungen derartiger Verbundkörper können Gründe vorhanden sein, die einen sehr kleinen Filamentdurchmesser wünschenswert machen.

Die Aufgabe der vorliegenden Erfindung besteht nun darin, ein Verfahren anzugeben, das die Vorteile der beiden erläuterten, bekannten Verfahren in sich vereinigt.

Bei dem eingangs genannten Verfahren entsprechend dem Oberbegriff des Patentanspruchs 1 besteht die Erfindung darin, daß die Matte aus zueinanden parallelen Längsdrähten (A, B) mit kreisrundem Querschnitt zusammen mit im wesentlichen senkrecht dazu verlaufenden Verbindungsdrähten (C) so gewebt oder geflochten wird, daß der Abstand der Längsdrähte (A, B) voneinander kleiner ist als der Abstand der Verbindungsdrähte (C).

Vorteilhafte Weiterbildungen des erfindungsgemäßen Verfahrens sind in den Unteransprüchen beschrieben.

Die Figuren 1 und 2 zeigen in zwei Ansichten das Entstehen einer gewebten Matte, wie sie zur Durchführung des erfindungsgemäßen Verfahrens verwendet wird.

Figur 3 zeigt den Aufrollvorgang und Figur 4 einen Querschnitt durch einen die aufgerollte Matte haltenden Bolzen vor der querschnittsvermindernden Verformung.

Figur 5 zeigt den Querschnitt von Einkerndrähten, die als Längsdrähte Verwendung finden können.

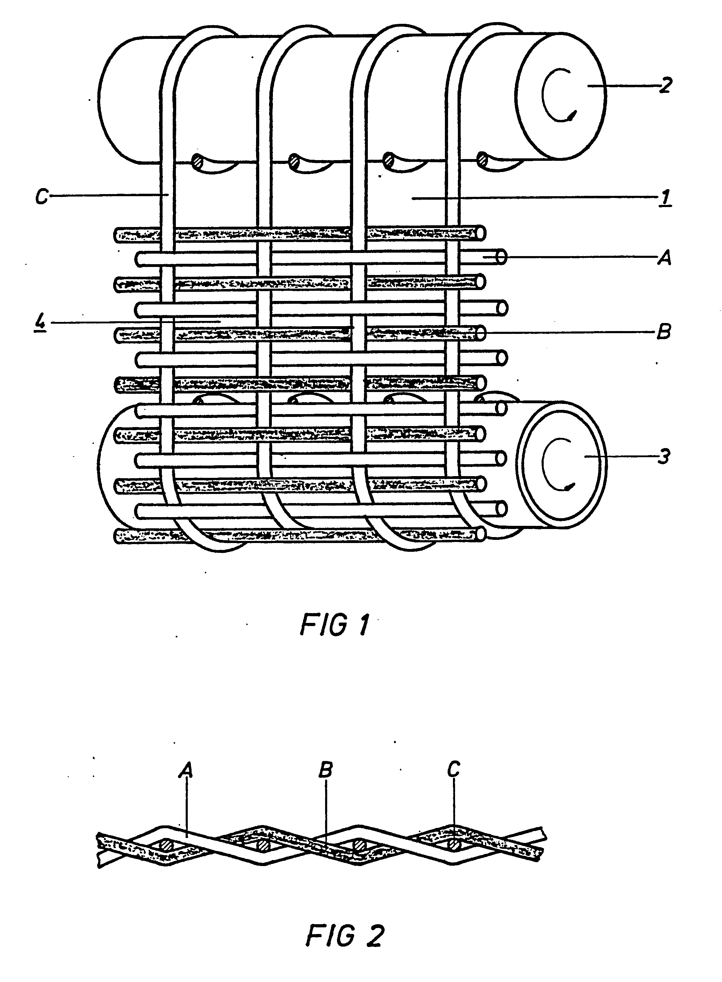

In den Figuren 1 und 2 wird angenomnen, daß allgemein ein Verbundkörper aus zwei verschiedenen Materialien hergestellt werden soll. Es werden jeweils mit A die Längsdrähte bezeichnet, die später die Filamente bilden sollen, während B Längsdrähte sind, die aus sonstigem Material des Verbundkörpers bestehen und die hier die Aufgabe haben, die Längsdrähte A voneinander zu separieren. Senkrecht dazu verlaufen Verbindungsdrähte C, die die Funktion der beim Weben zu verwendenden Kette erfüllen und teilweise als Lochfäden und als Schlitzfäden fungieren. Die Verbindungsdrähte C bestehen wie die Längsdrähte B aus einem sonstigen Material des Verbundkörpers, so daß benachbarte Längsdrähte A nicht durch Brücken aus gleichem Material verbunden sind. Die Verbindungsdrähte C bilden zusammen eine Kette 1, die von einem Kettbaum 2 abgewickelt wird. Die fertige Matte mit den eng aneinander liegenden Längsdrähten A und B wird dann, wie beim Webvorgang üblich, auf einen Warenbaum 3 aufgewickelt.

Selbstverständlich können auch andere der bekannten Web- oder Flechtverfahren Verwendung finden. Es wäre auch denkbar, die Richtung der Verbindungs- und Längsdrähte zu vertauschen, allerdings würde sich dadurch der Nachteil ergeben, daß die auf den Warenbaum gewickelte Matte 4 senkrecht zu der in Figur 1 dargestellten Richtung aufgewickelt werden muß und wegen der begrenzten Breite des Webstuhles nicht beliebig lang gemacht werden kann.

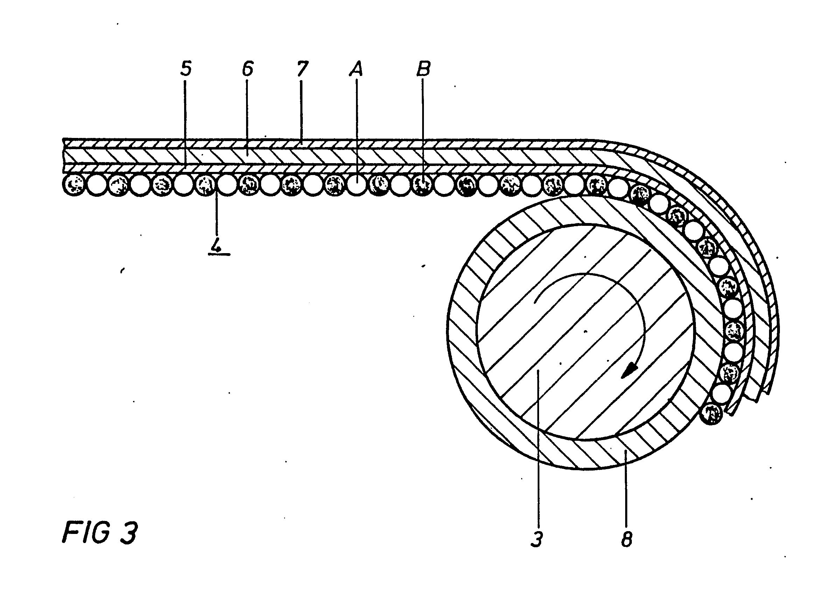

In Figur 3 sei angenommen, daß die Längsdrähte A aus Niob und die Längsdrähte B aus Kupfer bestehen und daß ein Supraleiter hergestellt werden soll. Von der Matte 4 sind in Figur 3 nur die Längsdrähte dargestellt. Figur 3 stellt also einen Schnitt durch die Matte 4 in Figur 1 parallel und zwischen zwei Verbindungsdrähten C dar. In dem angenommenen Fall eines Supraleiters besteht der Warenbaum 3 aus einem Kupferstab, der von einer diffusionshemmenden Schicht 8 aus Tantal ungeben ist, auf den zuerst die Matte 4, dann eine Folie 5 aus Kupfer, dann eine Folie 6 aus Zinn und wiederum eine Folie 7 aus Kupfer aufgewickelt wird. Wenn die Matte 4 (entsprechend Figur 3) voll aufgewickelt ist, erhält man so einen Bolzen, bei dem jeder Längsdraht A von Kupfer (Längsdraht B, Folie 5 und 7) umgeben ist und bei dem sich zwischen je zwei Kupferfolien eine Zinnfolie befindet. Wird dieser Bolzen durch Pressen und Ziehen auf seinen Endquerschnitt gebracht, so kann bei der bei Supraleitern üblichen Wärmebehandlung das Zinn durch das Kupfer in die Niobstäbe eindiffundieren und dort die Niob-reiche supraleitende Schicht $Nb_3Sn$ bilden. Der aus Kupfer mit einer diffusionshemmenden Schicht 8 bestehende Warenbaum dient bei diesem Beispiel zur Stabilisierung des Leiters.

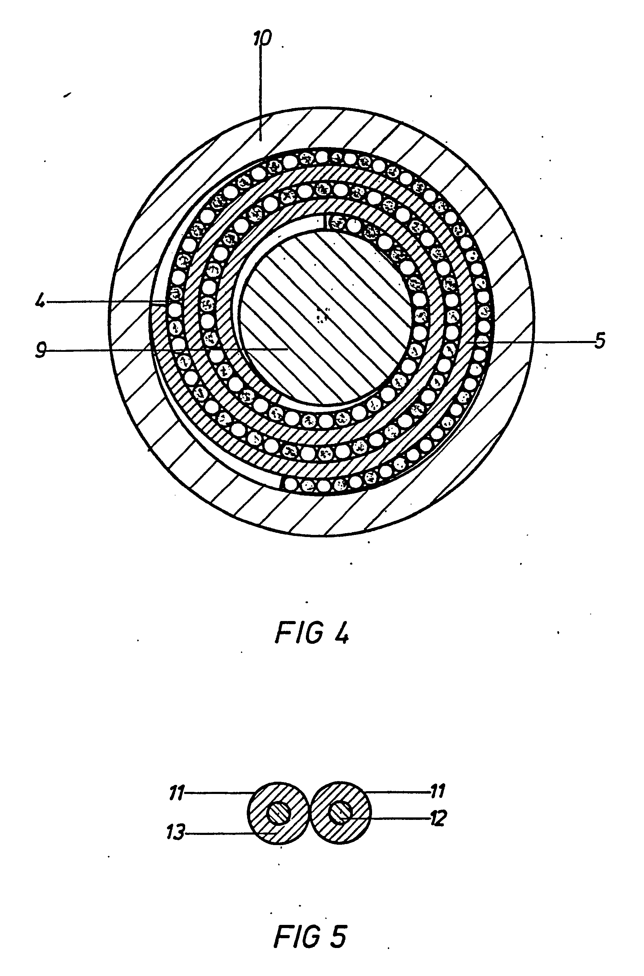

In Figur 4 ist nun der Querschnitt eines Verbundkörpers dargestellt, bei dem zwischen zwei Lagen der Matte 4 jeweils eine Folie 5 aus Kupfer zwischengelegt ist. Der Kern 9 in Figur 4 besteht hierbei ebenfalls aus Kupfer und das Ganze ist in einem Kupferrohr 10 eingeschlossen. Der so aufgebaute Bolzen kann nun in einer Presse bei hohen Temperaturen verformt werden.

Bei diesem Ausführungsbeispiel läßt sich aus dem in Figur 4 im Querschnitt dargestellten Bolzen ein Rohr pressen oder durch Ausbohren eines Teiles des Kerns 9 ein Rohr erhalten. Dieses Rohr wird dann anschließend mit Zinn oder einer zinnreichen Kupferlegierung gefüllt, verschlossen und auf den Endquerschnitt des Verbundkörpers gezogen.

Dieses Verfahren besitzt den Vorteil, daß bezogen auf den gesamten Querschnitt sehr viele Filamente in dem Verbundkörper untergebracht werden können und trotzdem eine ausreichende Menge Zinn zur Bildung der supraleitenden Schichten vorhanden ist. Hierdurch ergeben sich im Falle eines $Nb_3Sn$-Supraleiters sehr hohe Stromdichten, gemessen über den gesamten Querschnitt des Leiters. Bei der sonst verwendeten Kupfer-Zinn-Bronze als sonstiges Material des Verbundkörpers lassen sich wegen der notwendigen Verformbarkeit lediglich Bronzen mit bis zu 13,5 Gew.-% Zinn verwenden. Hierdurch und durch die bei der Mehrfachbündelung notwendigen Zwischenlagen zwischen einzelnen Bündeln von Filamenten war man bisher gezwungen, eine ungleichmäßige Verteilung der Bronze vorzunehmen, so daß die in dem zuerst gefertigten Bündel enthaltenen Filamente von einer dünnen Bronzehülle, die Bündel dagegen von einer dicken Bronzehülle ungeben sind. Um jedoch bei der Querschnittsreduktion eine Berührung der Filamente und damit erhöhte Wechselstromverluste zu vermeiden, muß eine gleichmäßige Verteilung der Filamente angestrebt werden. Außerdem wird durch den niedrigen Zinngehalt die Dicke der Bronzeschicht vorgegeben, welche im allgemeinen größer ist als diejenige, die eine Separation der Filamente sicherstellt.

Da bei dem anhand von Figur 4 beschriebenen Verfahren reines Zinn nach dem Warmpressen in den Kern hereingebracht wird, ist es in Verbindung mit der Webtechnik jetzt möglich, eine ausreichende Zinnmenge bei wesentlich geringerem Querschnitt unterzubringen. Damit wächst der Anteil der Filamente bezogen auf das Substratmaterial (z. B. Kupfer im Falle von $Nb_3Sn$-Supraleitern) und es läßt sich eine größere Stromtragfähigkeit bezogen auf den Leiterquerschnitt erzielen. Ähnliches kann für Festigkeitseigenschaften von sonstigen Verbundkörpern gelten, da es dieses Verfahren gestattet, sehr viele Filamente bei wenig sonstigem Material (Substratmaterial) im Querschnitt unterzubringen.

Eine weitere Möglichkeit zur Herstellung des erfindungsgemäßen Verbundkörpers wird anhand von Figur 5 erläutert. Hier sind zwei Querschnitte von Längsdrähten 11 dargestellt, die im Gegensatz zu den Längsdrähten A und B in den Figuren 1 bis 3 je aus einem Einkernverbundmaterial bestehen. Der Kern 12 besteht bei jedem der Einkernverbunddrähte 11 aus dem Material, aus dem die Filamente des herzustellenden Verbundkörpers bestehen sollen, während der Mantel 13 aus dem sonstigen Material besteht, in das die Filamente einzubetten sind. Verwendet man derartige Einkernverbunddrähte 11 als Längsdrähte entsprechend den anhand der Figuren 1 bis 3 geschilderten Ausführungsbeispielen, so müssen nicht mehr Längsdrähte aus verschiedenen Materialien nebeneinander in die Matte 4 gewebt werden, sondern es genügt, nur Einkernverbunddrähte 11 vorzusehen. Auch beim Aufwickeln der Matte 4 auf den Warenbaum 3 ist es nicht mehr nötig, zwischen die einzelnen Lagen der Matte 4 eine Folie zu legen. Den Mantel 13 eines derartigen Einkernverbunddrahtes 11 kann man auch aus einer Gallium oder Zinn enthaltenden Bronze herstellen und die daraus hergestellte Matte auf einen mit einer diffusionshemmenden Schicht versehenen Kupferkern wickeln. In diesem Fall ist das zur Bildung der supraleitenden Schicht verwendete Material in der Bronze des Mantels 13 enthalten und der Kupferkern wirkt als Stabilisierung für den Leiter.

Der Verbundkörper kann im Prinzip aus allen verformbaren Materialien aufgebaut werden.

Bei der Verwendung des Verbundkörpers als Supraleiter lassen sich anstelle der geschilderten, aus Niob und Zinn gebildeten Supraleiter auch andere Supraleitermaterialien, wie z. B. Gallium und Vanadium einsetzen.

## Patentansprüche

1. Verfahren zur Herstellung eines draht- bzw. stabförmigen Verbundkörpers mit einer Vielzahl von Filamenten, die im wesentlichen parallel zur Längsachse des Verbundkörpers verlaufen und mit Abstand voneinander in den Verbundkörper eingebettet und durch querschnittsvermindernde Verformung mit dem übrigen Material des Verbundkörpers fest verbunden sind, wobei die Filamente vor der Verformung zunächst in Form einer Matte (4) vorliegen und die Matte (4) zu einer Rolle aufgewickelt wird,
dadurch gekennzeichnet,
daß die Matte (4) aus zueinander parallelen Längsdrähten (A, B) mit kreisrundem Querschnitt zusammen mit im wesentlichen senkrecht dazu verlaufenden Verbindungsdrähten (C) so gewebt oder geflochten wird, daß der Abstand der Längsdrähte (A, B) voneinander kleiner ist als der Abstand der Verbindungsdrähte (C).

2. Verfahren zur Herstellung eines draht- bzw. stabförmigen Verbundkörpers nach Anspruch 1,
dadurch gekennzeichnet,
daß die Matte (4) gewebt wird und daß beim Weben die von einem Kettbaum (2) abgewickelte Kette (1) aus den Verbindungsdrähten (C) besteht, während die Längsdrähte (A, B) als Schußfäden verwendet werden.

3. Verfahren zur Herstellung eines draht- bzw. stabförmigen Verbundkörpers nach Anspruch 1,
dadurch gekennzeichnet,
daß die Längsdrähte (A) aus dem für die Filamente vorgesehenen Material bestehen und daß zwischen zwei derartigen Längsdrähten (A) jeweils mindestens ein weiterer Längsdraht (B), der aus einem sonstigen Material des Verbundkörpers besteht, angeordnet wird.

4. Verfahren zur Herstellung eines draht- bzw. stabförmigen Verbundkörpers nach Anspruch 1,
dadurch gekennzeichnet,
daß zwischen je zwei Lagen der Matte (4) mindestens eine Folie (5, 6, 7) aus sonstigem Material des Verbundkörpers zwischengewickelt wird.

5. Verfahren zur Herstellung eines draht- bzw. stabförmigen Verbundkörpers nach Anspruch 1 zur Herstellung eines Supraleiters
dadurch gekennzeichnet,
daß zwischen zwei Lagen einer aus Niob- und Kupfer- bestehenden Längsdrähten hergestellten und aufgewickelten Matte (4) je eine Kupfer-Folie (5), eine Zinn-Folie (6) und eine weitere Kupfer-Folie (7) gewickelt wird.

6. Verfahren zur Herstellung eines draht- bzw. stabförmigen Verbundkörpers nach Anspruch 5,
dadurch gekennzeichnet,
daß anstelle von Niob Vanadium und anstelle von Zinn Gallium eingesetzt wird.

7. Verfahren zur Herstellung eines draht- bzw. stabförmigen Verbundkörpers nach Anspruch 1,
dadurch gekennzeichnet,
daß alle Längsdrähte (A und B) aus Einkernverbunddrähten (11) mit je einem Kern (12) aus dem für die Filamente vorgesehenen Material und einem Mantel (13) aus dem sonstigen Material des Verbundkörpers bestehen.

8. Verfahren zur Herstellung eines draht- bzw. stabförmigen Verbundkörpers nach Anspruch 1 zur Verwendung des Verbundkörpers als Supraleiter
dadurch gekennzeichnet,
daß die Matte (4) Längsdrähte (A) aus Niob bzw. Vanadium und Längsdrähte (B) aus Kupfer enthält, daß diese Matte (4) zusammen mit einer Folie aus Kupfer oder Bronze mit Zinn bzw. Gallium-Gehalt auf einen Warenbaum (3), der aus einem Kupferstab besteht aufgewickelt wird, und der entstandene Wickelköper durch Heißpressen auf einen kleineren Querschnitt zu einem Rohr verformt wird, und daß in das Innere dieses Rohres das zur Bildung der supraleitenden Schicht notwendige weitere Zinn bzw. Gallium eingebracht wird.

9. Verfahren nach Anspruch 7, dadurch gekennzeichnet, daß der Mantel (13) des Einkernverbunddrahtes (11) aus Bronze besteht und daß die aus Einkernverbunddrähten (11) gewebte oder geflochtene Matte auf einen Kupferkern unter Zwischenschaltung eines Diffusionshemmers gewickelt wird, so daß der Kupferkern als Stabilisierungsmaterial wirkt.

## Claims

1. A method of manufacturing a wire-shaped or rod-shaped compound body with a plurality of filaments, which essentially run parallel to the longitudinal axis of the compound body, are embedded in the compound body with spaces between one another and are securely fixed to the remainder of the material of the compound body by deformation which reduces the cross-section, the filaments first being in the form of a mat (4) before deformation and the mat (4) being wound up into a roll, characterised in that the mat (4) is woven or braided from parallel longitudinal wires (A, B) having a circular cross-section, together with connecting wires (C) running substantially perpendicular thereto in such a way that the spaces between the longitudinal wires (A, B) are smaller than the spaces between the connecting wires (C).

2. A method of manufacturing a wire-shaped or rod-shaped compound body as claimed in Claim 1, characterised in that the mat (4) is woven and that in the weaving, the warp (1) which is unwound from a warp roller (2) consists of the connecting wires (C), whilst the longitudinal wires (A, B) are used as the weft threads.

3. A method of manufacturing a wire-shaped or rod-shaped compound body as claimed in Claim 1, characterised in that the longitudinal wires (A) are made of the material provided for the filaments; and that, between any two longitudinal wires of this type (A), there is located at least one other longitudinal wire (B), which is made of another material of the compound body.

4. A method of manufacturing a wire-shaped or rod-shaped compound body as claimed in Claim 1, characterised in that at least one foil (5, 6, 7) of other material of the compound body is interwound between each two layers of the mat (4).

5. A method of manufacturing a wire-shaped or rod-shaped compound body as claimed in Claim 1 for the manufacture of a superconductor, characterised in that between each two layers of a mat manufactured from longitudinal wires made of niobium and copper and wound up, in each case a copper foil (5), a tin foil (6) and another copper foil (7) are interwound.

6. A method of manufacturing a wire-shaped or rod-shaped compound body as claimed in Claim 5, characterised in that instead of niobium, vanadium is used, and instead of tin, gallium is used.

7. A method of manufacturing a wire-shaped or rod-shaped compound body as claimed in Claim 1, characterised in that all longitudinal wires (A & B) consist of single-core compound wires, each with a core (12) made of the material provided for the filaments and a sheath (13) made of the other material of the compound body.

8. A method of manufacturing a wire-shaped or rod-shaped compound body as claimed in Claim 1, when the compound body is to be used as a superconductor, characterised in that the mat (4) contains longitudinal wires (4) of niobium or vanadium and longitudinal wires (B) of copper; that this mat is interwound with a foil of copper or bronze with a content of tin or gallium on a roller (3) which consists of a copper rod and the resulting wound body is deformed by hot pressing to form a tube of reduced cross-section; and that the extra tin or gallium necessary for the formation of the superconducting layer is introduced into the inside of this tube.

9. A method as claimed in Claim 7, characterised in that the sheath (13) of the single-core compound wire (11) consists of bronze; and that the mat woven or braided from single-core compound wires (11) is wound on to a copper core with the interposition of a diffusion inhibitor, so that the copper core acts as stabilising material.

## Revendications

1. Procédé pour la fabrication d'un corps composite, en forme de câble ou de barre, comportant une pluralité de filaments qui s'étendent sensiblement parallèlement à l'axe longitudinal de ce corps composite, incorporés dans ce corps composite en étant séparés les une des autres par une certaine distance et qui sont reliés solidement avec le reste des matières qui constituent le corps composite par un travail de formation qui diminue la section, les filaments se présentant d'abord sous la forme d'une nappe du type dit "matte" (4), cette "matte" (4) étant enroulée en un rouleau, procédé caractérisé en ce que la matte (4) est tissée, ou entrelacée, à partir de fils longitudinaux parallèles (A, B), dont la section est circulaire, en commun avec des fils de liaison (C) qui s'étendent essentiellement parallèlement aux précédents, dans des conditions telles que la distance qui sépare les fils longitudinaux (A, B) est plus petite que celle qui sépare les fils (C) de liaison.

2. Procede pour la fabrication d'un corps composite en forme de câble ou de barre suivant la revendication 1, caractérisé en ce que la matte (4) est tissée, et qu'au cours du tissage, les fils de chaine (1), déroulés à partir d'une ensouple (2), sont constitués par les fils (C) de liaison, pendant que les fils longitudinaux (A, B) sont utilisés comme fils de trame.

3. Procédé suivant la revendication 1, caractérisé en ce que les fils longitudinaux (A) sont constitués par la matière prévue pour les filaments, et qu'entre deux fils longitudinaux de ce type (A), est placé, chaque fois, au moins, un autre fil longitudinal (B) qui est constitué par une autre matière entrant dans la composition du corps composite.

4. Procédé pour la fabrication d'un corps composite en forme de câble ou de barre suivant la revendication 1, caractérisé en ce qu'entre deux couches de matte (4), il est interposé, par enroulement, au moins une feuille (5, 6, 7) d'une autre matière rentrant dans la composition du corps composite.

5. Procédé pour la fabrication d'un corps composite en forme de câble ou de barre suivant la revendication 1, pour la fabrication d'un supra-conducteur, caractérisé en ce qu'entre deux couches d'une matte (4), fabriquée à partir de fils longitudinaux constitués par du niobium et par du cuivre, et qu'on enroule, sur la matte enroulée, chaque fois une feuille de cuivre (5), une feuille d'étain (6), et une autre feuille de cuivre (7).

6. Procédé pour la fabrication d'un corps composite en forme de câble ou de barre, suivant la revendication 5, caractérisé en ce que l'on incorpore, au lieu de niobium, du vanadium, et au lieu d'étain, du gallium.

7. Procédé pour la fabrication d'un corps composite en forme de câble ou de barre, suivant la revendication 1, caractérisé en ce que tous les fils longitudinaux (A et B) sont constitués par des fils composites mononucléaires (11) comportant chacun un noyau (12) fait de la matière prévue pour les filaments, et d'une enveloppe (13) faite de l'autre matière du corps composite.

8. Procédé pour la fabrication d'un corps composite en forme de câble ou de barre, suivant la revendication 1, destiné à être utilise comme supra-conducteur, caractérisé en ce que la matte (4) contient des fils longitudinaux (A) en niobium, ou en vanadium, et des fils longitudinaux (B) en cuivre, que cette matte (4) est enroulée, en commun avec une feuille de cuivre ou de bronze ayant une certaine teneur en étain ou en gallium, sur une ensouple (3) qui est faite d'une barre de cuivre, et que la pièce enroulée obtenue est façonnée, par pressage à chaud à une section transversale plus petite, en un tube, et que, dans l'intérieur de ce tube, on introduit le reste de l'étain ou du gallium nécessaire pour la formation d'une couche supra-conductrice.

9. Procédé suivant la revendication 7, caractérisé en ce que l'enveloppe (13) du fil composite (11) mononucléaire est faite de bronze, et que la matte (4), tissée ou entrelacée à partir des fils composites (11) mononucléaires, est enroulée sur un noyau en cuivre, avec interposition d'un inhibiteur de diffusion, de sorte que le noyau de cuivre agit comme matière stabilisante.

FIG 1

FIG 2

FIG 3

FIG 4

FIG 5